# FASCICULE DE BREVET EUROPEEN

(11) **EP 3 475 117 B1**
(45) Date de publication et mention de la délivrance du brevet: **04.03.2020**
(21) Numéro de dépôt: 17742806.7
(22) Date de dépôt: 20.06.2017
(51) Int. Cl.: B60L 3/00, H02H 3/14, H02M 1/32, H01M 2/10, H01M 10/42, H05K 7/14, B60K 6/405, H05K 5/00

(54) **MODULE D'ÉLECTRONIQUE DE PUISSANCE SÉCURISÉ POUR LA MAINTENANCE**
ELEKTRONISCHES MODUL FÜR LEISTUNGSSICHERHEIT BEI DER WARTUNG
ELECTRONIC MODULE FOR POWER SAFETY AT MAINTENANCE

(30) Priorité: 28.06.2016 FR 1656016
(43) Date de publication de la demande: 01.05.2019
(73) Titulaire: Renault S.A.S., 92100 Boulogne-Billancourt (FR)
(72) Inventeur: BOUGEARD, Stephan, 78190 trappes (FR); TEXIER, Roselyne, 91200 Athis-Mons (FR)
(86) Numéro de dépôt international: PCT/FR2017/051634
(87) Numéro de publication internationale: WO 2018/002479

(56) Documents cités:
- WO-A1-2015/129171
- WO-A2-2009/112165
- DE-A1-102014 000 683
- JP-A- H0 937 562

## Description

La présente invention se rapporte de manière générale au domaine de l'électrotechnique et concerne plus précisément un module d'électronique de puissance sécurisé pour la maintenance.

Les groupes motopropulseurs électriques pour voitures à traction/propulsion électriques ou hybrides comprennent un nombre important de composants, en plus du moteur électrique et de la batterie de traction. Ces composants comprennent l'onduleur de traction, mais aussi des inductances ou des capacités qui restent sous tension après l'arrêt du véhicule. Il existe donc un risque d'électrocution pour un opérateur effectuant une maintenance sur un tel groupe motopropulseur électrique.

Les opérateurs effectuant la maintenance de groupes motopropulseurs électriques sont sensés respecter certaines règles de sécurité. Notamment il leur est demandé d'effectuer une vérification d'absence de tension avant d'intervenir sur un module d'électronique de puissance, tel qu'un onduleur ou une inductance. Or dans la majorité des cas, les capacités en lien électrique avec les modules d'électroniques de puissance sont déjà déchargées lors d'une maintenance. Il y a donc un risque qu'un opérateur de maintenance omette d'effectuer la vérification d'absence de tension par habitude de constater cette absence de tension. Le document DE102014000683A1 divulgue un module d'électronique de puissance d'un système de traction électrique d'un véhicule électrique ou hybride, selon l'état de la technique.

Le document GB2357197 propose un système d'électronique de puissance comportant une capacité et un circuit de décharge connecté à la capacité. Tant que la capacité est connectée au système, un conducteur court-circuite le circuit de décharge. Lorsque la capacité est déconnectée du système, elle emporte le circuit de décharge mais pas le conducteur qui est solidaire du reste du système, ce qui permet la décharge de la capacité.

Cette solution limite les risques électriques, mais ne protège toutefois pas un opérateur d'un tel risque pendant le temps de décharge de cette capacité.

Il existe donc un besoin de renforcer la sécurité électrique pour la maintenance sur les modules d'électroniques de puissance de véhicules électriques ou hybrides.

Un des buts de l'invention est de remédier à au moins une partie des inconvénients de la technique antérieure en fournissant un module d'électronique de puissance peu coûteux et permettant de limiter les risques électriques pour un opérateur de maintenance intervenant sur un tel module.

A cette fin, l'invention propose un module d'électronique de puissance d'un système de traction électrique d'un véhicule électrique ou hybride, comportant un carter abritant un élément sous tension lorsque ledit système est en fonctionnement, ledit élément étant accessible via un couvercle dudit carter, la fixation dudit couvercle sur ledit carter étant assurée par des moyens de fixation démontables, caractérisé en ce qu'il comporte des moyens de blocage du démontage desdits moyens de fixation, lesdits moyens de blocage étant connectés à un dispositif de sécurité apte à activer un circuit de décharge d'au moins une capacité liée audit élément sous tension lorsque lesdits moyens de blocage sont désactivés.

Grâce à l'invention, un opérateur de maintenance voulant intervenir sur l'élément sous tension, devra, pour avoir accès aux moyens de fixation permettant d'ouvrir le couvercle du module d'électronique de puissance, désactiver les moyens de blocage ce qui déchargera les capacités liées à l'élément sous tension. Contrairement à l'art antérieur, l'accès à l'élément sous tension n'est pas possible directement après le début de la décharge des capacités liées à l'élément sous tension due à la coupure du courant venant de la batterie par le dispositif de sécurité, puisque l'opérateur doit encore démonter les moyens de fixation du couvercle sur le carter du module d'électronique de puissance, pour avoir accès à l'élément sous tension. Les capacités en amont du module seront donc déjà bien déchargées avant que l'opérateur puisse le toucher, ce qui diminue fortement le risque d'un choc électrique, même lorsque la vérification d'absence de tension a été omise.

Selon une caractéristique avantageuse du module d'électronique de puissance selon l'invention, lesdits moyens de blocage comportent une plaque vissée sur ledit couvercle, ladite plaque comportant des ouïes aptes à recouvrir des moyens de fixation dudit couvercle audit carter.

Cette mise en œuvre a l'avantage d'être simple et peu coûteuse à réaliser.

Selon une autre caractéristique avantageuse du module d'électronique de puissance selon l'invention, lesdits moyens de blocage comportent un pion en appui sur une lamelle ressort fermant un circuit électrique de détection de la désactivation desdits moyens de blocage, ledit circuit électrique de détection étant apte à activer, à l'ouverture dudit circuit électrique de détection, ledit circuit de décharge.

Cette réalisation du dispositif de sécurité est simple et permet de réutiliser des systèmes de décharge déjà existants dans le commerce,

Selon une autre caractéristique avantageuse du module d'électronique de puissance selon l'invention, lesdits moyens de fixation dudit couvercle et ledit circuit de décharge sont dimensionnés de sorte que le temps de démontage manuel dudit couvercle après désactivation des moyens de blocage permet la décharge d'au moins 95% de ladite au moins une capacité liée audit élément sous tension.

L'invention concerne aussi un système de traction électrique d'un véhicule électrique ou hybride comportant un module d'électronique de puissance selon l'invention.

Le système de traction électrique selon l'invention présente des avantages analogues à ceux du module d'électronique de puissance selon l'invention.

D'autres caractéristiques et avantages apparaîtront à la lecture d'un mode de réalisation préféré décrit en référence aux figures dans lesquelles :
- la figure 1 représente, dans ce mode de réalisation préféré, un module d'électronique de puissance selon l'invention, dans lequel des moyens de blocage empêchent le démontage du couvercle dudit module d'électronique de puissance ;
- et la figure 2 représente, dans ce mode de réalisation préféré, ce module d'électronique de puissance dans lequel les moyens de blocage ont été désactivés.

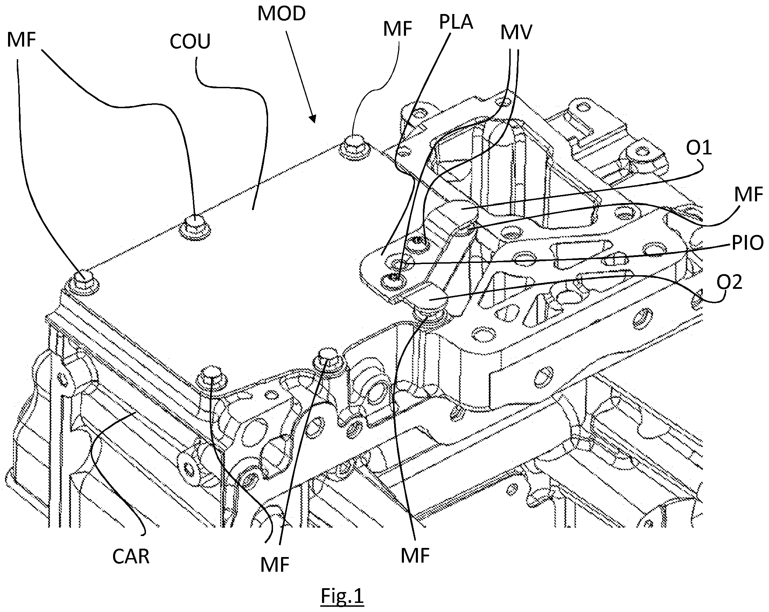

Selon un mode de réalisation préféré de l'invention représenté à la **figure 1**, un module d'électronique de puissance MOD d'un système de traction électrique d'un véhicule électrique ou hybride comporte un élément qui est sous tension lors du fonctionnement normal du système de traction électrique du véhicule. Cet élément est par exemple une inductance ou une capacité. Il est protégé dans le module d'électronique de puissance MOD, par un carter CAR, et est accessible par un opérateur de maintenance en ouvrant un couvercle COU du carter CAR. Le module d'électronique de puissance MOD comprend donc l'élément capacitif et/ou inductif mais aussi des éléments propres à son intégration dans le système de traction électrique du véhicule, tels que son carter CAR, des connexions, etc.

Pour ouvrir le couvercle COU, un opérateur de maintenance doit démonter des moyens de fixation MF, ici des vis, permettant de fixer le couvercle COU sur le carter CAR. Certaines de ces vis ne peuvent être dévissées directement, car elles sont recouvertes par des ouïes O1 et O2 d'une plaque PLA vissée sur le couvercle COU par d'autres vis MV. L'opérateur de maintenance doit donc d'abord dévisser la plaque PLA, pour pouvoir dévisser toutes les vis assurant la fixation du couvercle COU sur le carter CAR, et donc pour pouvoir ouvrir le couvercle COU.

Les ouïes O1 et O2 de la plaque PLA constituent donc des moyens de blocage du démontage du couvercle COU. Ceux-ci sont désactivés lorsque la plaque PLA est dévissée et retirée du couvercle COU.

La plaque PLA comporte dans sa zone central un pion PIO faisant saillie vers l'intérieur du carter CAR, faisant appui sur une lamelle ressort LR qui ferme un circuit électrique permettant de détecter la désactivation des moyens de blocage que constituent la plaque PLA et ses ouïes O1 et O2.

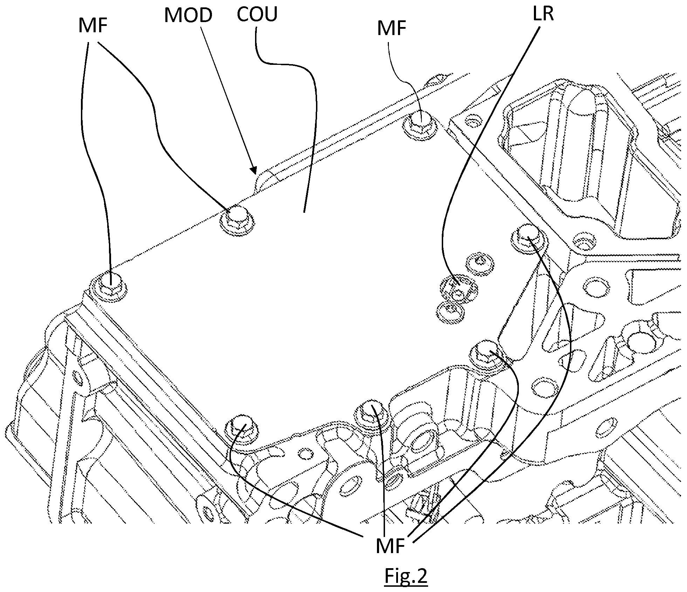

En effet lorsque la plaque PLA est ôtée du couvercle COU, comme représenté à la **figure 2**, la lamelle ressort LR se déplie ce qui ouvre le circuit électrique de détection de la désactivation des moyens de blocage. Cette ouverture déclenche la décharge des capacités liées à l'élément sous tension présent dans le module d'électronique de puissance MOD, par exemple en activant un circuit de décharge tel que celui décrit dans le document GB2357197. Il est à noter que les capacités liées à l'élément sous tension peuvent être l'élément sous tension lui-même s'il est de nature capacitive.

En variante, le soulèvement de la plaque PLA est détecté par un photodétecteur, relié à un module électronique commandant un circuit de décharge des capacités liées à l'élément sous tension. Il est à noter qu'il est possible d'utiliser un circuit de décharge très simple constitué de résistances reliées par exemple directement aux capacités liées à l'élément sous tension.

De préférence, le nombre de vis MF sur le couvercle COU permettant l'ouverture de celui-ci après le dévissage de la plaque PLA, et le circuit de décharge, sont dimensionnés de manière à ce que la décharge des capacités liées à l'élément sous tension soit presque complète à l'ouverture du couvercle COU. Ainsi, si l'élément capacitif à décharger est une capacité de lissage de 10mF (millifarads), son temps de décharge dans une résistance de 300 Ω est de l'ordre de la seconde, ce qui dépasse largement le temps de dévissage des deux vis MF venant d'être débloquées après avoir ôté la plaque PLA du couvercle COU.

## Revendications

1. Module d'électronique de puissance (MOD) d'un système de traction électrique d'un véhicule électrique ou hybride, comportant un carter (CAR) abritant un élément sous tension lorsque ledit système est en fonctionnement, ledit élément étant accessible via un couvercle (COU) dudit carter (CAR), la fixation dudit couvercle (COU) sur ledit carter (CAR) étant assurée par des moyens de fixation (MF) démontables, **caractérisé en ce qu'**il comporte des moyens de blocage (O1, O2) du démontage desdits moyens de fixation (MF), lesdits moyens de blocage (O1, O2) étant connectés à un dispositif de sécurité apte à activer un circuit de décharge d'au moins une capacité liée audit élément sous tension lorsque lesdits moyens de blocage (O1, O2) sont désactivés.

2. Module d'électronique de puissance (MOD) selon la revendication 1, **caractérisé en ce que** lesdits moyens de blocage (O1, O2) comportent une plaque (PLA) vissée sur ledit couvercle (COU), ladite plaque (PLA) comportant des ouïes (O1, O2) aptes à recouvrir des moyens de fixation (MF) dudit couvercle (COU) audit carter (CAR).

3. Module d'électronique de puissance (MOD) selon la revendication 1 ou 2, **caractérisé en ce que** lesdits moyens de blocage (O1, O2) comportent un pion (PIO) en appui sur une lamelle ressort (LR) fermant un circuit électrique de détection de la désactivation desdits moyens de blocage (O1, O2), ledit circuit électrique de détection étant apte à activer, à l'ouverture dudit circuit électrique de détection, ledit circuit de décharge.

4. Système de traction électrique d'un véhicule électrique ou hybride comportant un module d'électronique de puissance (MOD) selon l'une quelconque des revendications 1 à 3.

## Patentansprüche

1. Elektronisches Leistungsmodul (MOD) eines elektrischen Antriebssystems eines Elektro- oder Hybridfahrzeugs, beinhaltend ein Gehäuse (CAR), in dem ein Element, das bei Betrieb des Systems Spannung führt, untergebracht ist, wobei das Element über eine Abdeckung (COU) des Gehäuses (CAR) zugänglich ist, wobei die Befestigung der Abdeckung (COU) an dem Gehäuse (CAR) durch demontierbare Befestigungsmittel (MF) sichergestellt ist, **dadurch gekennzeichnet, dass** es Mittel zur Blockierung (O1, O2) der Demontage der Befestigungsmittel (MF) umfasst, wobei die Mittel zur Blockierung (O1, O2) mit einer Sicherheitsvorrichtung verbunden sind, die fähig ist, eine Schaltung zur Entladung mindestens eines Kondensators, der mit dem spannungsführenden Element verbunden ist, zu aktivieren, wenn die Mittel zur Blockierung (O1, O2) deaktiviert werden.

2. Elektronisches Leistungsmodul (MOD) nach Anspruch 1, **dadurch gekennzeichnet, dass** die Mittel zur Blockierung (O1, O2) eine Platte (PLA) umfassen, die auf den Deckel (COU) aufgeschraubt ist, wobei die Platte (PLA) Laschen (O1, O2) umfasst, die fähig sind, Mittel (MF) zur Befestigung des Deckels (COU) an dem Gehäuse (CAR) abzudecken.

3. Elektronisches Leistungsmodul (MOD) nach Anspruch 1 oder 2, **dadurch gekennzeichnet, dass** die Mittel zur Blockierung (O1, O2) einen Stift (PIO) umfassen, der an einem Federblatt (LR) anliegt, das eine elektrische Schaltung zur Detektion der Deaktivierung der Mittel zur Blockierung (O1, O2) schließt, wobei die elektrische Detektionsschaltung fähig ist, bei Öffnung der elektrischen Detektionsschaltung die Entladungsschaltung zu aktivieren.

4. Elektrisches Antriebssystem eines Elektro- oder Hybridfahrzeugs, das ein elektronisches Leistungsmodul (MOD) nach einem der Ansprüche 1 bis 3 umfasst.

## Claims

1. Electronic power module (MOD) for an electric drive system of an electric or hybrid vehicle, comprising a casing (CAR) housing an element that is under load when said system is functioning, said element being accessible via a cover (COU) of said casing (CAR), said cover (COU) being fixed on said casing (CAR) by detachable fixing means (MF), **characterized in that** it comprises means (O1, O2) for immobilizing the detachment of said fixing means (MF), said immobilizing means (O1, O2) being connected to a safety device capable of actuating a discharge circuit of at least one capacity linked to said element under load when said immobilizing means (O1, O2) are deactivated.

2. Electronic power module (MOD) according to Claim 1, **characterized in that** said immobilizing means (O1, O2) comprise a plate (PLA) screwed onto said cover (COU), said plate (PLA) comprising ears (O1, O2) capable of covering the fixing means (MF) of said cover (COU) to said casing (CAR).

3. Electronic power module (MOD) according to Claim 1 or 2, **characterized in that** said immobilizing means (O1, O2) comprise a stud (PIO) bearing on a leaf spring (LR) connecting an electrical circuit for detection of the deactivation of said immobilizing means (O1, 02), said electrical detection circuit being capable of activating said discharge circuit upon disconnection of said electrical detection circuit.

4. Electric drive system of an electric or hybrid vehicle comprising an electronic power module (MOD) according to any one of Claims 1 to 3.
